# EUROPEAN PATENT APPLICATION

(11) **EP 2 639 832 A2**
(43) Date of publication of application: **18.09.2013**
(21) Application number: 13157960.9
(22) Date of filing: 06.03.2013
(51) Int. Cl.: H01L 25/18, H01L 25/07

(54) **Group III-V and group IV composite diode**

(30) Priority: 15.03.2012 US 201261611369 P; 29.03.2012 US 201213434524; 28.02.2013 US 201313781080
(71) Applicant: International Rectifier Corporation, El Segundo, CA 90245 (US)
(72) Inventor: Briere, Michael A., Scottsdale, AZ 85266 (US); McDonald, Tim, Redondo Beach, CA 90277 (US)
(74) Representative: Dr. Weitzel & Partner

(57) **Abstract**

In one implementation, a group III-V and group IV composite diode includes a group IV diode in a lower active die, the group IV diode having an anode situated on a bottom side of the lower active die. The group III-V and group IV composite diode also includes a group III-V transistor in an upper active die stacked over the lower active die, the group III-V transistor having a drain, a source, and a gate situated on a top side of the upper active die. The source of the group III-V transistor is electrically coupled to a cathode of the group IV diode using a through-semiconductor via (TSV) of the upper active die.

## Description

### BACKGROUND

The present application claims the benefit of and priority to a pending provisional application entitled "Group III-Nitride and Group IV Leadless Packaged Composite Device," Serial No. 61/611,369 filed on March 15, 2012. The disclosure in this pending provisional application is hereby incorporated fully by reference into the present application. This application is a continuation-in-part of co-pending application Serial No. 13/434,524 filed on March 29, 2012, which in turn claims priority to provisional application Serial No. 61/473,907 filed on April 11, 2011. The disclosure of both these applications are also hereby incorporated fully by reference into the present application. The present application claims priority to all of these earlier filed applications.

### I. DEFINITIONS

As used herein, the phrase "group III-V" refers to a compound semiconductor including at least one group III element and at least one group V element. By way of example, a group III-V semiconductor may take the form of a III-Nitride semiconductor. "III-Nitride" or "III-N" refers to a compound semiconductor that includes nitrogen and at least one group III element such as aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), aluminum indium gallium arsenide phosphide nitride (AlₓIn_{y}Ga_{(1-x-y)}AsₐP_{b}N_{(1-a-b)}), for example. III-Nitride also refers generally to any polarity including but not limited to Ga-polar, N-polar, semi-polar, or non-polar crystal orientations. A III-Nitride material may also include either the Wurtzitic, Zincblende, or mixed polytypes, and may include single-crystal, monocrystalline, polycrystalline, or amorphous structures. Gallium nitride or GaN, as used herein, refers to a III-Nitride compound semiconductor wherein the group III element or elements include some or a substantial amount of gallium, but may also include other group III elements in addition to gallium.

Also as used herein, the phrase "group IV" refers to a semiconductor that includes at least one group IV element such as silicon (Si), germanium (Ge), and carbon (C), and may also include compound semiconductors such as silicon germanium (SiGe) and silicon carbide (SiC), for example. Group IV also refers to semiconductor materials which include more than one layer of group IV elements, or doping of group IV elements to produce strained group IV materials, and may also include group IV based composite substrates such as silicon on insulator (SOI), separation by implantation of oxygen (SIMOX) process substrates, and silicon on sapphire (SOS), for example.

Moreover, and as also used herein, the phrase "LV diode" refers to a low-voltage diode, while the phrase "HV transistor" refers to a high-voltage transistor. Typical voltage ratings include LV ~ OV-50V, midvoltage (MV) ~ 50V-300V, and HV ~ 300V-1200V.

### II. BACKGROUND ART

In high power and high performance circuit applications, group III-V transistors, such as III-Nitride field-effect transistors (FETs) and high mobility electron transistors (HEMTs), are often desirable for their high efficiency and high-voltage handling capability. Moreover, it is often desirable to combine such a III-Nitride transistor with a low-voltage (LV) group IV diode, such as an LV silicon diode, to produce a high performance composite diode.

For example, in applications for which normally OFF characteristics are desirable, a depletion mode (normally ON) III-Nitride or other group III-V power transistor can be coupled to an LV silicon or other LV group IV diode to produce a composite device functioning effectively as a diode. However, conventional techniques for combining III-Nitride transistors with silicon diodes often offset the benefits provided by III-Nitride transistors. For instance, conventional composite designs may place the III-Nitride transistor and silicon diode side-by-side on a common support surface. Such a side-by-side configuration can undesirably increase the parasitic inductance and resistance in the current paths of the composite diode, as well as its thermal dissipation requirements.

### SUMMARY

The present disclosure is directed to a group III-V and group IV composite diode, substantially as shown in and/or described in connection with at least one of the figures, and as set forth more completely in the claims.

### BRIEF DESCRIPTION OF THE DRAWINGS

Figure 1 shows a diagram of one exemplary implementation of a group III-V and group IV composite diode.
Figure 2A shows a perspective view of a top side of an exemplary group III-V transistor suitable for use in a group III-V and group IV composite diode, according to one implementation.
Figure 2B shows a perspective view of a bottom side of the exemplary group III-V transistor shown in Figure 2A.
Figure 2C shows a cross-sectional view of the exemplary group III-V transistor shown in Figures 2A and 2B from perspective 2C-2C in Figure 2A.
Figure 3A shows a perspective view of a top side of an exemplary group IV diode suitable for use in a group III-V and group IV composite diode, according to one implementation.
Figure 3B shows a perspective view of a bottom side of the exemplary group IV diode shown in Figure 3A.
Figure 4A shows a perspective view of an exemplary group III-V and group IV composite diode implemented using the transistor shown in Figures 2A, 2B, and 2C, and the diode shown by Figures 3A and 3B.
Figure 4B shows a cross-sectional view of the exemplary group III-V and group IV composite diode shown in Figure 4A from perspective 4B-4B in that figure.
Figure 5A shows a cross-sectional view of an exemplary group III-V and group IV composite diode, according to another implementation.
Figure 5B shows a cross-sectional view of an exemplary group III-V and group IV composite diode, according to yet another implementation.

### DETAILED DESCRIPTION

The following description contains specific information pertaining to implementations in the present disclosure. One skilled in the art will recognize that the present disclosure may be implemented in a manner different from that specifically discussed herein. The drawings in the present application and their accompanying detailed description are directed to merely exemplary implementations. Unless noted otherwise, like or corresponding elements among the figures may be indicated by like or corresponding reference numerals. Moreover, the drawings and illustrations in the present application are generally not to scale, and are not intended to correspond to actual relative dimensions.

As noted above, in high power and high performance circuit applications, group III-V transistors, such as transistors fabricated from III-Nitride materials, are often desirable for their high efficiency and high-voltage handling capability. III-Nitride materials include, for example, gallium nitride (GaN) and its alloys such as aluminum gallium nitride (AlGaN), indium gallium nitride (InGaN), and aluminum indium gallium nitride (AlInGaN). These III-Nitride materials are semiconductor compounds having a relatively wide, direct bandgap and strong piezoelectric polarizations, and can enable high breakdown fields, high saturation velocities, and the creation of two-dimensional electron gases (2DEGs). As a result, III-Nitride materials such as GaN are used in many microelectronic applications as depletion mode (i.e., normally ON) power field-effect transistors (power FETs) and high electron mobility transistors (HEMTs), for example.

As further noted above, in power applications for which normally OFF characteristics are desirable, a depletion mode III-Nitride or other normally ON transistor can be coupled with a low-voltage (LV) group IV diode to produce a composite device functioning as a diode. However, the utility and reliability of such a composite diode can be compromised by conventional techniques for combining III-Nitride or other group III-V transistors with silicon or other group IV diodes, which can negate the benefits provided by III-Nitride transistors. For example, conventional composite designs may place a III-Nitride transistor and a silicon diode side-by-side on a common support surface implemented using a ceramic based substrate such as a direct bonded copper (DBC) substrate, a ceramic substrate on a lead-frame, or an organic laminate substrate. Such side-by-side configuration can undesirably increase the parasitic inductance and resistance in the current paths of the composite diode. As a result, a compact and cost-effective design solution for integrating III-Nitride or other group III-V transistors with group IV diodes, such as silicon diodes, is needed.

Various approaches related to potential design solutions are described in U.S. Patent Application Number 13/433,864, entitled "Stacked Composite Device Including a Group III-V Transistor and a Group IV Lateral Transistor," filed on March 29, 2012; U.S. Patent Application Number 13/434,412, entitled "Stacked Composite Device Including a Group III-V Transistor and a Group IV Vertical Transistor," also filed on March 29, 2012; and U.S. Patent Application Number 13/434,524, entitled "Stacked Composite Device Including a Group III-V Transistor and a Group IV Diode," filed on March 29, 2012 as well, the entire disclosure of each of which is hereby incorporated fully by reference into the present application.

The present application is directed to a group III-V and group IV composite diode. According to one implementation, the composite diode may include a high-voltage (HV) III-Nitride power transistor cascoded with an LV group IV diode. The composite diode implementations disclosed by the present application are designed to substantially reduce parasitic inductance and resistance, as well as to enhance thermal dissipation when compared to conventional design solutions.

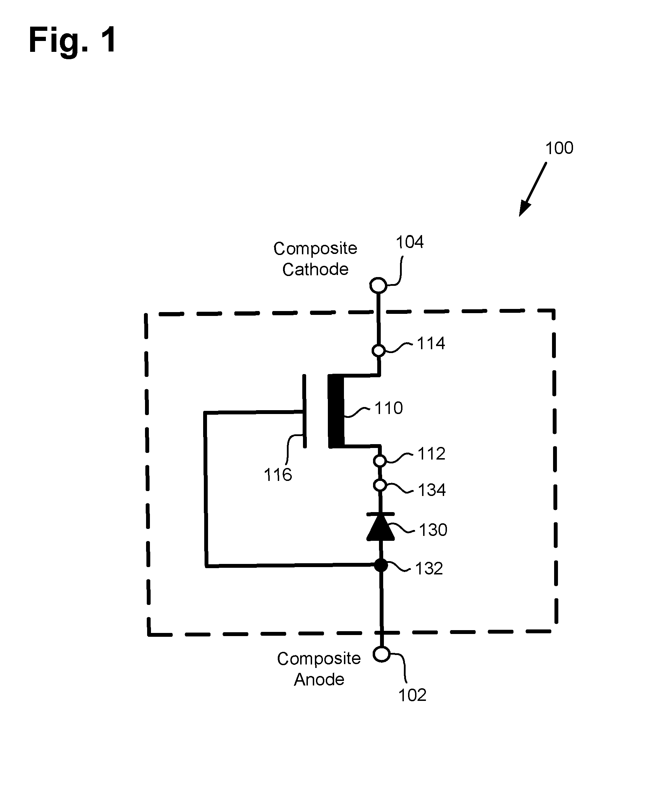

Referring to Figure 1, Figure 1 shows one exemplary implementation of a group III-V and group IV composite diode. Composite diode 100 includes group III-V transistor 110 coupled to group IV diode 130. Also shown in Figure 1 are composite anode 102 and composite cathode 104 of composite diode 100, as well as source 112, drain 114, and gate 116 of group III-V transistor 110, and anode 132 and cathode 134 of group IV diode 130.

Group III-V transistor 110 may be a normally ON III-Nitride power transistor and may be implemented as a depletion mode insulated-gate FET (IGFET), a junction FET (JFET), an accumulation mode FET (AccuFet), or as a heterostructure FET (HFET), for example. In one implementation, group III-V transistor 110 may take the form of a depletion mode metal-insulator-semiconductor FET (MISFET), such as a metal-oxide-semiconductor FET (MOSFET). Alternatively, when implemented as an HFET, group III-V transistor 110 may be a HEMT configured to produce a 2DEG. It is noted that in some implementations, composite diode 100 may utilize an insulated gate bipolar transistor (IGBT) as a power transistor in place of a group III-V FET or HEMT. It is further noted that composite diode 100 may utilize a group III-V FET or HEMT other than a III-N FET or HEMT, such as a III-As, III-P or III-AsₐP_{b}N_{(1-a-b)} FET or HEMT, for example, as group III-V transistor 110.

According to the implementation shown by Figure 1, group IV diode 130 may be LV silicon diode. However, in other implementations, group IV diode 130 may include any suitable group IV material. As shown in Figure 1, group III-V transistor 110 is coupled to group IV diode 130 to produce composite diode 100. That is to say, cathode 134 of group IV diode 130 is coupled to source 112 of group III-V transistor 110, anode 132 of group IV diode 130 provides composite anode 102 for composite diode 100, drain 114 of group III-V transistor 110 provides composite cathode 104 for composite diode 100, and gate 116 of group III-V transistor 110 is coupled to anode 132 of group IV diode 130.

The combination of group III-V transistor 110 and group IV diode 130 produces composite diode 100, which according to the implementation shown in Figure 1 results in a composite two terminal device functioning in effect as a diode having composite anode 102 provided by group IV diode 130, and composite cathode 104 provided by group III-V transistor 110. Moreover, and as will be described in greater detail below, composite diode 100 may be implemented as an HV composite diode configured to have reduced parasitic inductance and resistance, as well as enhanced thermal dissipation.

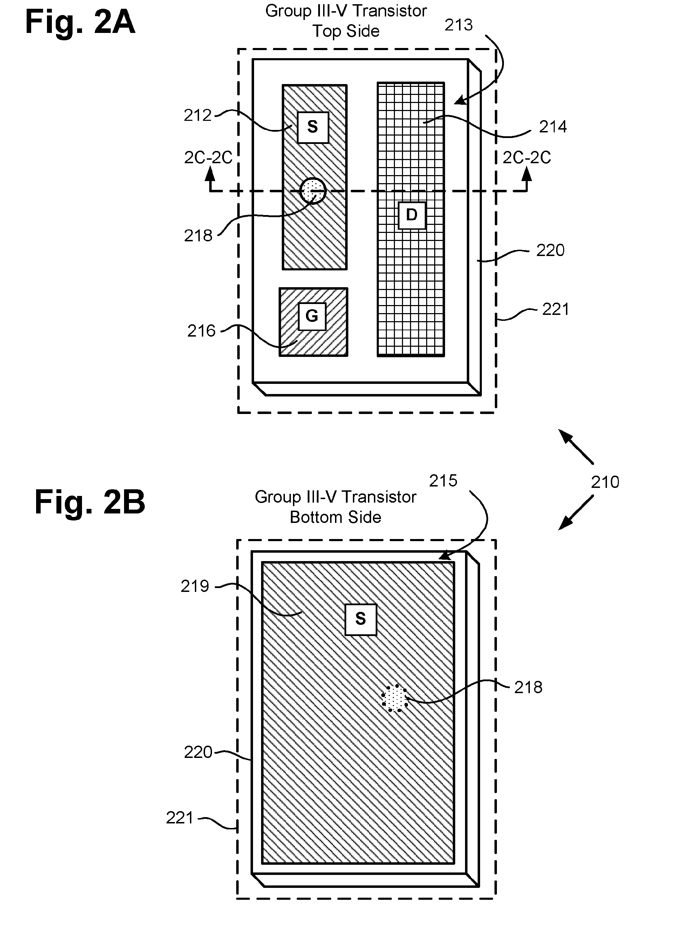

Continuing to Figures 2A and 2B, Figure 2A shows a perspective view of top side 213 of exemplary group III-V transistor 210 suitable for use in a group III-V and group IV composite diode, according to one implementation, while Figure 2B shows a perspective view of bottom side 215 of group III-V transistor 210. As shown by Figure 2A, group III-V transistor 210 includes active die 220 having lateral area 221 and including source electrode 212, drain electrode 214, and gate electrode 216 situated on top side 213 of active die 220. Source electrode 212, drain electrode 214, and gate electrode 216 correspond respectively to and are representative of the source, drain, and gate of group III-V transistor 210, situated on top side 213 of active die 220. Also shown in Figure 2A is top side terminus of through-semiconductor via (TSV) 218 of active die 220, for electrically coupling source electrode 212 to source contact 219 on bottom side 215 of active die 220 (source contact 219 and bottom side terminus of TSV 218 shown in Figure 2B).

It is noted that although the top side terminus of TSV 218 is visually depicted as though "seen through" source electrode 212 in the interests of conceptual clarity, in practice the top side terminus of TSV 218 would be obscured by source electrode 212 and thus would not be visible from the perspective view shown by Figure 2A. It is further noted that the bottom side terminus of TSV 218 is represented as having a dotted border and is depicted as though "seen through" source contact 219 on bottom side 215 of active die 220. In practice the bottom side terminus of TSV 218 would be obscured by at least the presence of source contact 219 and thus would not be visible from the perspective view shown by Figure 2B.

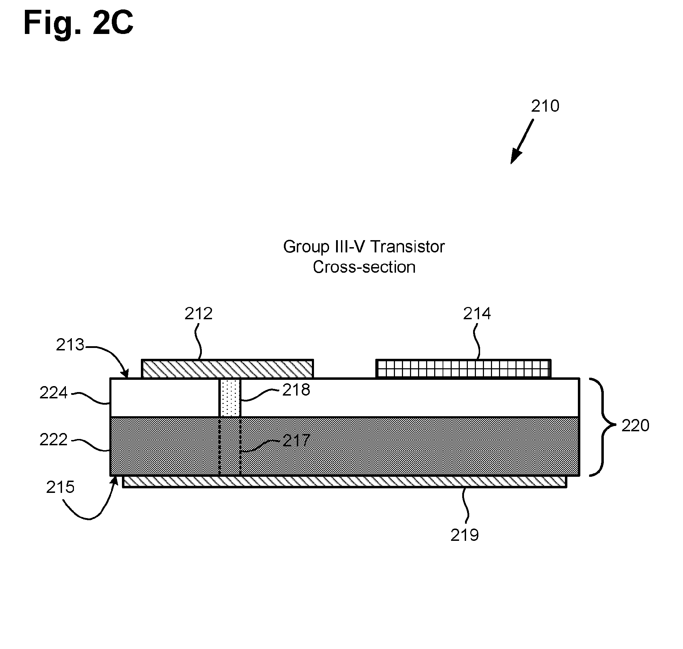

In some implementations, as will be described more fully below by reference to Figure 2C, TSV 218 may not extend through the entirety of active die 220, but rather may extend from source electrode 212 on top side 213 to reach a highly conductive substrate in active die 220. In such implementations, the highly conductive substrate may be formed as a silicon structure containing one or more layers. For example, the highly conductive substrate may include a lightly doped N type (i.e., N-) layer formed over a heavily doped N type (i.e., N+) layer. In certain implementations TSV 218 may extend through one or more layers within the highly conductive substrate to make contact with a highly conductive layer within the highly conductive substrate. In certain other implementations, the highly conductive substrate may be a silicon on insulator (SOI) substrate. In such an implementation, TSV 218 may extend down to either the thin device layer or layers formed over an insulating layer, or may extend down through the insulating layer to or into the handle layer formed below the insulating layer.

Although some of the implementations described below depict use of a single TSV, those of ordinary skill in the art will appreciate that other implementations of the present inventive principles may include multiple TSVs. Thus, as used herein, the term "through-semiconductor via" or "TSV" refers to at least one through-semiconductor via, but may include two or more through-semiconductor vias. In some implementations, the TSVs may be configured as an array of vias. Moreover, the TSVs may be distributed throughout the semiconductor structure (e.g., under the device electrodes), or they may be clustered together (e.g., under source or drain pads, or under one or more TSV pads), among other possible configurations.

Referring to Figure 2C, Figure 2C shows a cross-sectional view of exemplary group III-V transistor 210 from perspective 2C-2C in Figure 2A. As shown in Figure 2C, active die 220 having top side 213 and bottom side 215 includes substrate 222 and group III-V layer 224 formed over substrate 222. Also shown in Figure 2C are TSV 218, source electrode 212, drain electrode 214, and source contact 219 electrically coupled to source electrode 212 through substrate 222 and/or TSV 218, as indicated by dashed lines 217 extending TSV 218 through active die 220 in some implementations.

Although depicted as a single layer in Figure 2C, it is noted that group III-V layer 224 is typically implemented using multiple group III-V layers and includes a heterojunction configured to produce a 2DEG. For example, in some implementations, group III-V layer 224 may include a heterojunction formed from a GaN channel layer and an AlGaN barrier layer disposed over the GaN channel layer, and configured to provide a III-Nitride HEMT.

Substrate 222 may be formed of any commonly utilized substrate material. For example, substrate 222 may be formed of sapphire, or may be a group IV substrate as described above in the "Definitions" section. In implementations in which substrate 222 is a non-native substrate for group III-V layer 224 (e.g., a non group III-V substrate such as a silicon or other group IV substrate), group III-V layer 224 typically includes group III-V transition layers formed between substrate 222 and a group III-V heterojunction within group III-V layer 224. Such transition layers are configured to mediate the thermal coefficient of expansion mismatch between substrate 222 and the group III-V channel and barrier layers forming the group III-V heterojunction (i.e., GaN channel layer and AlGaN barrier layer). In such implementations, the specific compositions and thicknesses of the group III-V transition layers implemented as part of group III-V layer 224 may depend on the diameter and thickness of substrate 222, and the desired performance of group III-V transistor 210.

In some implementations, substrate 222 may be a highly conductive group IV substrate, such as a highly conductive silicon substrate, for example. It is noted that in implementations in which substrate 222 is highly conductive, TSV 218 need not extend through the entirety of active die 220 to electrically couple source electrode 212 and source contact 219 at bottom side 215 of active die 220. Instead, in those implementations, TSV 218 may extend from top side 213 of active die 220 only as far as necessary to reach highly conductive substrate 222. However, in implementations in which substrate 222 is not a highly conductive substrate, TSV 218 may extend through active die 220, as shown by dashed lines 217, to reach bottom side 215 of active die 220.

In other words, in some implementations, source electrode 212 and source contact 219 may be electrically coupled by TSV 218, while in other implementations, source electrode 212 and source contact 219 may be electrically coupled by TSV 218 and highly conductive substrate 222 in active die 220. It is noted that Group III-V transistor 210, shown by Figures 2A, 2B, and 2C, corresponds to group III-V transistor 110, in Figure 1, and may share any of the features previously attributed to that corresponding group III-V transistor, above.

Those of ordinary skill in the art will appreciate in light of the present disclosure that other transistor configurations may be implemented, including a variety of layouts to electrically couple different regions of the transistor. For example, the electrodes may be implemented as source, drain, and gate electrodes, wherein the source and drain electrodes are formed as interdigitated finger electrodes coupled to respective common source and drain pads, as disclosed in U.S. Patent Number 7,166,867, entitled "III-Nitride Device with Improved Layout Geometry," filed on December 3, 2004, the entire disclosure of which is hereby incorporated fully by reference into the present application.

It is noted that in certain implementations, source electrode 212 may correspond to a source finger electrode, or to a common source electrode pad coupling several source finger electrodes, or may correspond to a TSV pad coupled to one or more source electrode pads and/or one or more source finger electrodes. Those of ordinary skill in the art will appreciate that an analogous drain electrode configuration could also correspond to drain electrode 214 (i.e., drain electrode 214 corresponding to a drain finger electrode, drain finger electrode pad(s), or drain TSV pad(s)). It is further noted that, in some implementations, gate electrode 216 can correspond to a gate finger electrode, or to a common gate electrode pad coupling several gate finger electrodes, or may correspond to a TSV pad coupled to one or more gate electrode pads and/or one or more gate finger electrodes.

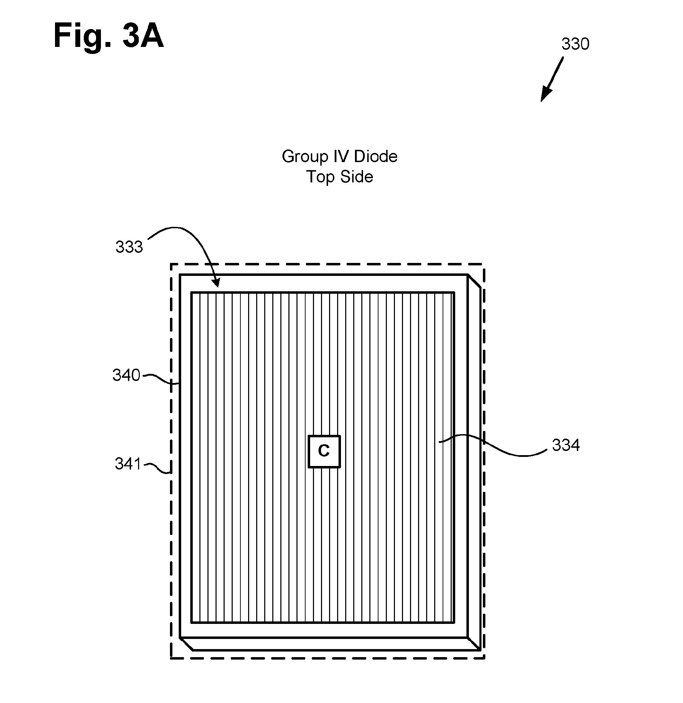

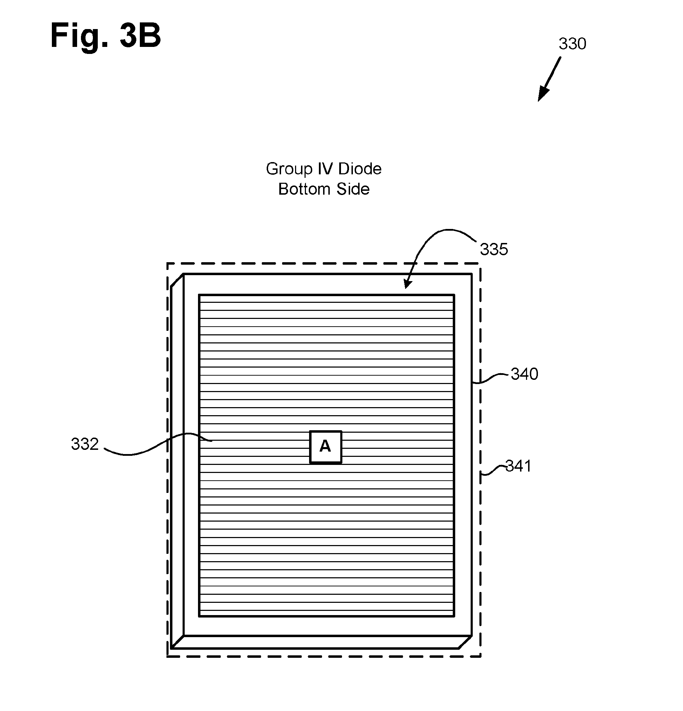

Moving to Figures 3A and 3B, Figure 3A shows a perspective view of top side 333, while Figure 3B shows a perspective view of bottom side 335, of exemplary group IV diode 330 suitable for use in a group III-V and group IV composite diode, according to one implementation. As shown by Figure 3A, group IV diode 330 includes active die 340 having lateral area 341. As further shown by Figure 3A, group IV diode 330 has cathode 334 situated on top side 333 of active die 340. Moreover, and as shown by Figure 3B, group IV diode 330 has anode 332 situated on bottom side 335 of active die 340.

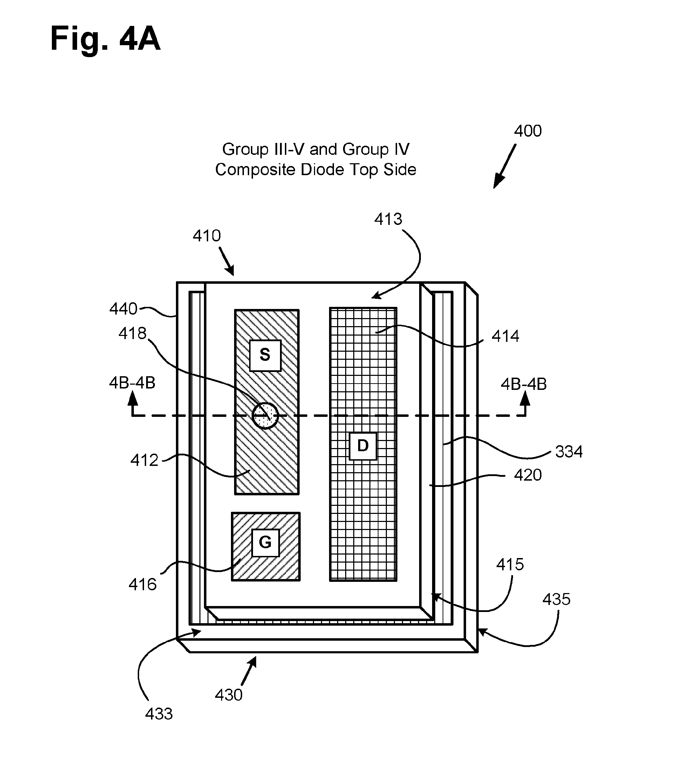

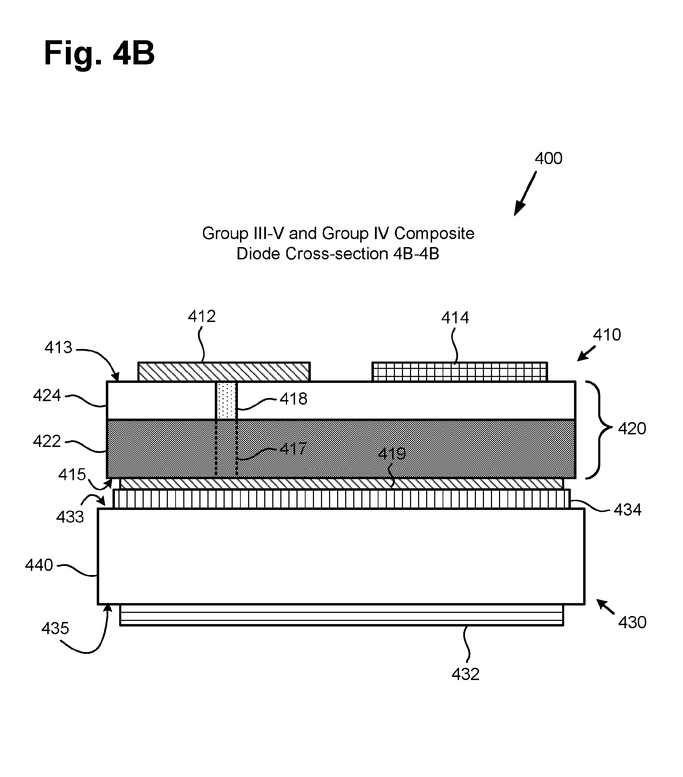

Referring now to Figures 4A and 4B, Figure 4A shows a perspective view of exemplary group III-V and group IV composite diode 400 implemented using the transistor shown by Figures 2A, 2B, and 2C, and the diode shown by Figures 3A, and 3B. Figure 4B shows a cross-sectional view of composite diode 400 from perspective 4B-4B in Figure 4A. As shown in Figures 4A and 4B, composite diode 400 is depicted as having a stacked configuration in which active die 420 including group III-V transistor 410 is stacked over active die 440 including group IV diode 430. Thus, according to the present implementation, active die 440 is a lower active die of composite diode 400, and active die 420 is an upper active die stacked over lower active die 440.

Composite diode 400 corresponds in general to composite diode 100, in Figure 1. Moreover, group IV diode 430, in Figures 4A and 4B corresponds to group IV diode 330, in Figures 3A and 3B. Thus, group IV diode 430 may be an LV silicon diode having anode 432 on bottom side 435 of lower active die 440, and cathode 434 on top side 433 of lower active die 440.

In addition, group III-V transistor 410 corresponds to group III-V transistor 210, in Figures 2A, 2B, and 2C. Thus, group III-V transistor 410 may be an HV 111-Nitride transistor, such as an HV GaN based HEMT, for example. Substrate 422, group III-V layer 424, TSV 418, and dashed lines 417 extending TSV 418 through upper active die 420 in some implementations correspond respectively to substrate 222, group III-V layer 224, TSV 218, and dashed lines 217, in Figure 2C. Moreover, drain electrode 414, source electrode 412, the top side terminus of TSV 418, and gate electrode 416, correspond respectively to drain electrode 214, source electrode 212, the top side terminus of TSV 218, and gate electrode 216, in Figure 2A. It is noted that although the top side terminus of TSV 418, in Figure 4A, depicted as though "seen through" source electrode 412, the top side terminus of TSV 418 would in fact not be visible from the perspective of Figure 4A. Also shown in Figure 4B is source contact 419 on bottom side 415 of upper active die 420.

As explained above by reference to Figure 2C, in some implementations, substrate 422, in Figure 4B may be a highly conductive group IV substrate, such as a highly conductive silicon substrate. Moreover, and as shown by Figure 4B, in implementations in which substrate 422 is highly conductive, TSV 418 need not extend through the entirety of upper active die 420 to electrically couple source electrode 412 to cathode 434 of group IV diode 430. That is to say, in some implementations, TSV 418 in upper active die 420 reaches bottom side 415 of upper active die 420, while in other implementations TSV 418 does not reach bottom side 415. Furthermore, in some implementations, highly conductive substrate 422 is in electrical contact with cathode 434 of group IV diode 430, and TSV 418 reaches highly conductive substrate 422 in upper active die 420 to couple source electrode 412 of group III-V transistor 410 to cathode 434 of group IV diode 430.

According to the implementation shown in Figures 4A and 4B, composite diode 400 includes a composite anode provided by anode 432 of group IV diode 430. In addition, composite diode 400 includes a composite cathode provided by drain electrode 414 of group III-V transistor 410. Moreover, gate electrode 416 of group III-V transistor 410, situated on top side 413 of upper active die 420, can be electrically coupled to anode 432 of group IV diode 430, situated on bottom side 435 of lower active die 440 to produce a composite diode corresponding to composite diode 100, in Figure 1.

As shown in Figures 4A and 4B, composite diode 400 may be formed by stacking bottom side 415 of group III-V transistor 410 having source contact 419 formed thereon directly on top of cathode 434 of group IV diode 430. In that implementation, upper active die 420 can be aligned such that source contact 419 of group III-V transistor 410 makes direct contact with cathode 434 of group IV diode 430. Stacking of group III-V transistor 410 on top of group IV diode 430 may be achieved using, for example, solder, conductive adhesive, conductive tape, sintering, or other attachment methods, resulting in formation of a direct mechanical contact between group III-V transistor 410 and group IV diode 430. Such direct attachment of group III-V transistor 410 to group IV diode 430 can advantageously reduce parasitic inductance and resistance, improve thermal dissipation, and reduce form factor and manufacturing cost compared to conventional composite diode designs.

With respect to the exemplary composite diode implementation shown in Figures 4A and 4B it is noted that the features and characteristics represented by that specific example are depicted in detail merely as a conceptual aid, and are not to be interpreted as limitations. It is further noted that implementational details such as dimensions and layouts, for example, may be highly dependent upon the particular group III-V transistor and group IV diode being utilized and the particular purpose for which the composite diode is designed.

For example, according to the present implementation, lower active die 440 has a larger lateral area (corresponding to lateral area 341, in Figures 3A and 3B) than a lateral area of upper active die 420 (corresponding to lateral area 221, in Figures 2A and 2B). However, that need not be the case in all implementations. Thus, in some implementations, the respective lateral areas of lower active die 440 and upper active die 420 may be similar or substantially equal. In those implementations in which active dies 440 and 420 have similar or substantially equal lateral areas, the topology of composite diode 400 may be flipped so that group IV diode 430 in active die 440 is stacked over group III-V transistor 410 in active die 420. Consequently, in some implementations active die 420 may serve as the lower active die of composite diode 400, while active die 440 is implemented as the composite diode upper active die.

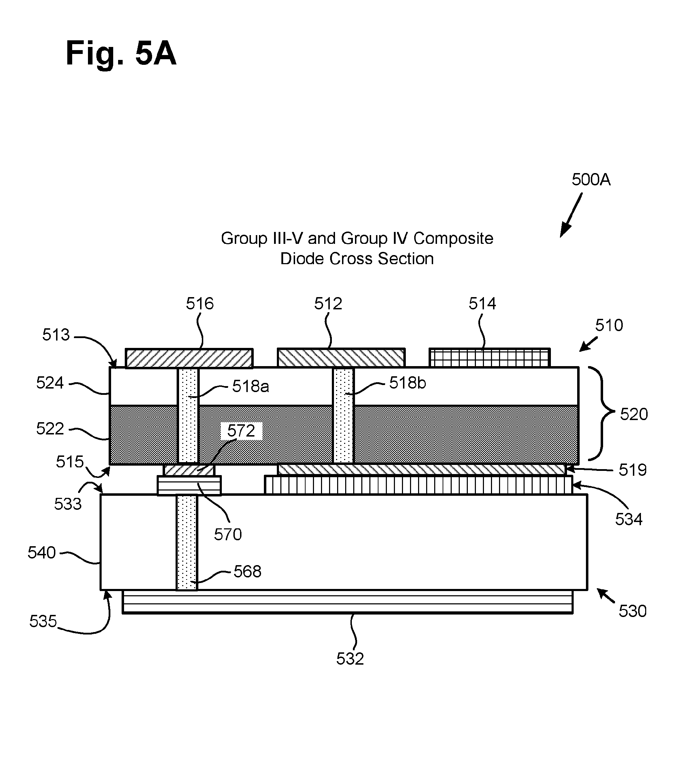

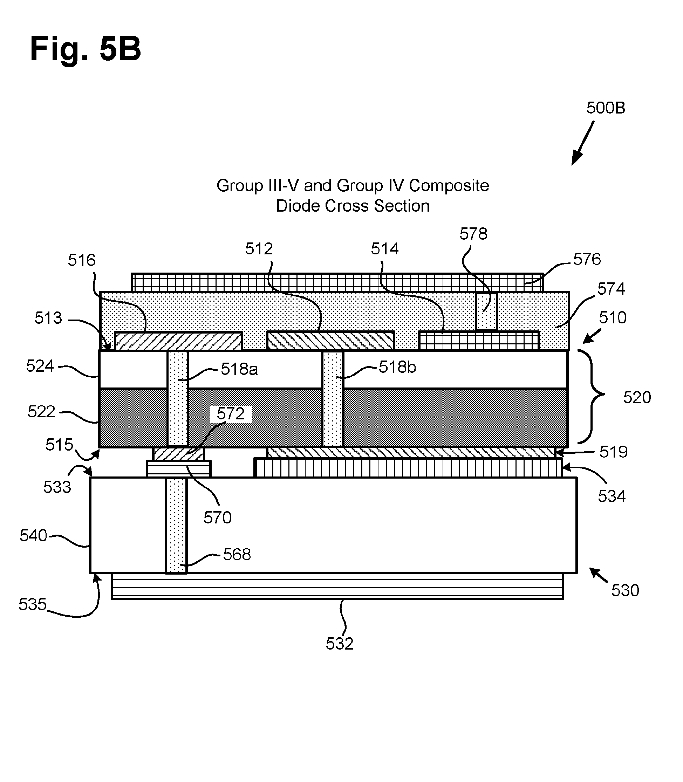

Referring now to Figures 5A and 5B, Figures 5A and 5B show cross-sectional views of respective group III-V and group IV composite diodes 500A and 500B, according to other exemplary implementations. It is noted that exemplary composite diodes 500A and 500B incorporate the use of at least one TSV in the active die of the group III-V transistor coupled to another TSV in the active die of the group IV diode. Composite diodes 500A and 500B each includes group III-V transistor 510 with active die 520, and group IV diode 530 having active die 540. It is noted that composite diodes 500A and 500B correspond in general to composite diode 100, in Figure 1.

As shown in Figures 5A and 5B, group IV diode 530 has an anode corresponding to anode electrode 532 situated on bottom side 535 of lower active die 540. In addition, and as further shown by Figures 5A and 5B, group IV diode 530 includes TSV 568 and TSV-anode interconnect 570 coupled to TSV 568 at top side 533 of lower active die 540, as well as a cathode corresponding to cathode electrode 534 on top side 533.

Group III-V transistor 510 may be a group III-V transistor having a substrate 522, group III-V layer 524, TSVs 518a and 518b, and TSV-gate interconnect 572 coupled to TSV 518a at bottom side 515 of upper active die 520. In addition, group III-V transistor 510 includes drain electrode 514, source electrode 512, and gate electrode 516 situated on top side 513 of upper active die 520. It is noted that TSV 518a is coupled at its top side terminus to gate electrode 516 of group III-V transistor 510, and at its bottom side terminus to TSV-gate interconnect 572. It is also noted that TSV 568 is coupled at its top side terminus to TSV-anode interconnect 570 and at its bottom side terminus to anode electrode 532 of group IV diode 530.

Figures 5A and 5B further show source contact 519 situated on bottom side 515 of upper active die 520 and electrically coupled to source electrode 512 by TSV 518b. Also shown in Figure 5B are insulator layer 574, drain contact 576 for group III-V transistor 510, and via 578 electrically coupling drain contact 576 to drain electrode 514 on top side 513 of upper active die 520.

According to the implementations shown in Figures 5A and 5B, composite diodes 500A and 500B include a composite cathode electrode provided by drain electrode 514 in Figure 5A, and by drain contact 576 in Figure 5B. Moreover, gate electrode 516 of group III-V transistor 510, situated on top side 513 of upper active die 520, can be electrically coupled to anode electrode 532 of group IV diode 530, situated on bottom side 535 of lower active die 540, through TSV 518a, TSV-gate interconnect 572, TSV-anode interconnect 570, and TSV 568. Once electrically coupled to gate electrode 516 of group III-V transistor 510, anode electrode 532 of group IV diode 530 is configured to provide a composite anode electrode of composite diodes 500A and 500B.

As shown in Figures 5A and 5B, composite diodes 500A and 500B may be formed by stacking bottom side 515 of group III-V transistor 510 having source contact 519 and TSV-gate interconnect 572 formed thereon directly on top of cathode electrode 534 and TSV-anode interconnect 570, respectively, of group IV diode 530. In that implementation, upper active die 520 can be aligned such that source contact 519 of group III-V transistor 510 makes direct contact with cathode electrode 534 of group IV diode 530. Also, TSV-gate interconnect 572 can make direct contact with TSV-anode interconnect 570. Stacking of group III-V transistor 510 on top of group IV diode 530 may be achieved using, for example, solder, conductive adhesive, conductive tape, sintering, or other attachment methods, resulting in formation of a direct mechanical contact between group IV diode 530 and group III-V transistor 510. Such direct attachment of group IV diode 530 to group III-V transistor 510 can advantageously reduce parasitic inductance and resistance, improve thermal dissipation, and reduce form factor and manufacturing cost compared to conventional composite switch designs.

Referring to Figure 5B, composite diode 500B includes substantially all of the features of composite diode 500A, in Figure 5A. However, the top side of composite diode 500B further includes planar drain pad or drain contact 576. Drain contact 576 is coupled to drain electrode 514 through via 578 formed within insulator layer 574. According to the implementation shown in Figure 5B, insulator layer 574 should have sufficient thickness to prevent breakdown of insulator layer 574 between drain contact 576 and either gate electrode 516 or source electrode 512.

From the above description it is manifest that various techniques can be used for implementing the concepts described in the present application without departing from the scope of those concepts. Moreover, while the concepts have been described with specific reference to certain implementations, a person of ordinary skill in the art would recognize that changes can be made in form and detail without departing from the scope of those concepts. As such, the described implementations are to be considered in all respects as illustrative and not restrictive. It should also be understood that the present application is not limited to the particular implementations described herein, but many rearrangements, modifications, and substitutions are possible without departing from the scope of the present disclosure.

## Claims

1. A composite diode comprising:
a group IV diode in a lower active die, an anode of said group IV diode being situated on a bottom side of said lower active die;
a group III-V transistor in an upper active die stacked over said lower active die, a drain, a source, and a gate of said group III-V transistor being situated on a top side of said upper active die;
said source of said group III-V transistor being electrically coupled to a cathode of said group IV diode using a through-semiconductor via (TSV) of said upper active die.

2. The composite diode of claim 1, wherein said cathode of said group IV diode is situated on a top side of said lower active die.

3. The composite diode of claim 1, wherein said TSV does not reach a bottom side of said upper active die.

4. The composite diode of claim 1, wherein said TSV reaches a highly conductive substrate in said upper active die, said highly conductive substrate being in electrical contact with said cathode of said group IV diode.

5. The composite diode of claim 1, wherein said TSV reaches a bottom side of said upper active die.

6. The composite diode of claim 1, wherein said group III-V transistor is a normally ON transistor.

7. The composite diode of claim 1, wherein said group III-V transistor is a high-voltage (HV) transistor and said group IV diode is a low-voltage (LV) diode.

8. The composite diode of claim 1, wherein said group III-V transistor is a III-Nitride high electron mobility transistor (III-Nitride HEMT).

9. The composite diode of claim 1, wherein said group III-V transistor comprises gallium nitride (GaN).

10. The composite diode of claim 1, wherein said group IV diode comprises silicon.

11. A III-Nitride-silicon composite diode comprising:
a silicon diode in a lower active die, an anode of said silicon diode being situated on a bottom side of said lower active die;
a III-Nitride transistor in an upper active die stacked over said lower active die, a drain, a source, and a gate of said III-Nitride transistor being situated on a top side of said upper active die;
said source of said III-Nitride transistor being electrically coupled to a cathode of said silicon diode using a through-semiconductor via (TSV) of said upper active die.

12. The III-Nitride-silicon composite diode of claim 11, wherein said cathode of said silicon diode is situated on a top side of said lower active die.

13. The III-Nitride-silicon composite diode of claim 11, wherein said TSV does not reach a bottom side of said upper active die.

14. The III-Nitride-silicon composite diode of claim 11, wherein said TSV reaches a highly conductive substrate in said upper active die, said highly conductive substrate being in electrical contact with said cathode of said silicon diode.

15. The III-Nitride-silicon composite diode of claim 11, wherein said TSV reaches a bottom side of said upper active die.
